# EUROPEAN PATENT APPLICATION

(11) **EP 4 595 843 A1**
(43) Date of publication of application: **06.08.2025**
(21) Application number: 25153226.3
(22) Date of filing: 22.01.2025
(51) Int. Cl.: A47K 5/12, B05B 12/08, H02N 2/18, B05B 11/10

(54) **MANUALLY OPERATED DISPENSER WITH KINETIC POWER GENERATOR**

(30) Priority: 02.02.2024 US 202463549229 P
(71) Applicant: OP-Hygiene IP GmbH, 4704 Niederbipp (CH)
(72) Inventor: Issler, David, 3380 Wangen an der Aare (CH); Ophardt, Heiner, 4422 Arisdorf (CH)
(74) Representative: Grünecker Patent- und Rechtsanwälte PartG mbB

(57) **Abstract**

A system that includes a manually activated product dispenser and an interface member that is positioned between the manually activated product dispenser and a support structure. The interface member includes a kinetic power generator and a communication device. The interface member is configured so that, on manual activation of the manually activated product dispenser, an activation force is transmitted to the kinetic power generator. On application of the activation force to the kinetic power generator, the kinetic power generator is configured to generate electrical power, which activates the communication device. On activation, the communication device is configured to transmit a message.

## Description

### Related Application

This application claims priority to the 2 February 2024 filing date of United States Provisional Patent Application Serial No. 63/549,229, which is incorporated herein by reference.

### Field of the Invention

This invention relates to hygiene product dispensers, and more particularly to manually operated hygiene product dispensers such as hand cleaning fluid dispensers, paper towel dispensers, and bathroom tissue dispensers.

### Background of the Invention

Hygiene product dispensers are known in which an actuator is manually activated by a user in order to dispense the hygiene product from the dispenser. For example, United States Patent No. 10,893,780 to Ophardt et al., issued 19 January 2021, discloses a fluid dispenser having a pump mechanism that dispenses fluid when a horizontal activating force is manually applied to a front facing actuator panel of the dispenser. United States Patent No. 7,748,573 to Anhuf et al., issued 6 July 2010, discloses another dispenser construction in which the pump mechanism is activated by manually applying a downwards force to an actuator lever. U.S. Patent Nos. 10,893,780 and 7,748,573 are both incorporated herein by reference.

It is also known to provide hygiene product dispensers with smart functionality. For example, United States Patent No. 11,389,035 to Lang et al., issued 19 July 2022, discloses a fluid dispenser having a smart nozzle shield that carries a number of electronic components, including a battery, a microcontroller, a communication device, an activation sensor, a pump position sensor, and a bottle detector. The smart nozzle shield can be used to provide a number of smart functions, such as calculating the amount of fluid that has been dispensed and/or that is remaining in the dispenser, and transmitting this data to an external device. U.S. Patent No. 11,389,035 is incorporated herein by reference.

### Summary of the Invention

To at least partially overcome some of the disadvantages of previously known systems, devices and methods, in one aspect the present invention provides a system that includes a manually activated product dispenser and an interface member that is positioned between the manually activated product dispenser and a support structure. The interface member includes a kinetic power generator and a communication device. The interface member is configured so that, on manual activation of the manually activated product dispenser, an activation force is transmitted to the kinetic power generator. On application of the activation force to the kinetic power generator, the kinetic power generator is configured to generate electrical power, which activates the communication device. On activation, the communication device is configured to transmit a message.

The applicant has appreciated that the system in accordance with the present invention preferably allows a manually activated hygiene product dispenser to be provided with smart functionality, without requiring a battery or an external source of electrical power. Instead, the electrical power required for the smart function or functions can be generated from the activation force that is provided manually by the user. Eliminating the need for a battery can preferably significantly reduce the cost of providing smart functionality. It can also significantly reduce the cost of maintenance, as changing or recharging batteries can be a major cost item in large installations.

Preferably, the communication device is configured to transmit a very simple message that does not require significant power to generate or transmit. The message may, for example, be in the form of a low energy, short lived radio signal that identifies the dispenser that has been activated, such as by incorporating a dispenser ID number. As an example, transmission of the message could be achieved with RF signal modulations, such as OOK (On-Off-Keying). The signal is preferably received by an external receiver, which allows the external receiver to monitor the activations of the dispenser over time. The receiver can, for example, calculate or estimate the quantity of the hygiene product remaining in the dispenser based on the number of activations detected over time, and generate a maintenance alert when it is determined that the dispenser needs to be refilled. As another example, the receiver could also use the detection of dispenser activations to monitor and rate hand hygiene compliance such as in a hospital or other healthcare facility.

In some preferred embodiments, the kinetic power generator and the communication device are incorporated into a mounting structure for the dispenser, such as a wall mount. This preferably allows smart functionality to be easily incorporated into an existing manually operated dispenser, without requiring extensive modifications to the dispenser itself. Preferably, the mounting structure is capable of being used with a variety of different manually activated dispensers, so as to provide a universal or nearly universal method of providing smart functionality to both new and existing hygiene product dispensers.

In some embodiments of the invention, the message transmitted by the communication device on activation of the dispenser may include additional information about the status of the dispenser, such as whether the dispenser and/or a reservoir of the dispenser has emptied below a settable threshold.

Further aspects of the invention include:
A system, which optionally incorporates one or more features of any one or more of the preceding and/or following aspects, comprising: a manually activated product dispenser; and an interface member that is positioned between the manually activated product dispenser and a support structure; wherein the interface member comprises: a kinetic power generator; and a communication device; wherein the interface member is configured so that, on manual activation of the manually activated product dispenser, an activation force is transmitted to the kinetic power generator; wherein, on application of the activation force to the kinetic power generator, the kinetic power generator is configured to generate electrical power; wherein the communication device is activated by the electrical power generated by the kinetic power generator; and wherein, on activation, the communication device is configured to transmit a message.

A system, which optionally incorporates one or more features of any one or more of the preceding and/or following aspects, wherein the interface member comprises a mount for mounting the manually activated product dispenser to the support structure.

A system, which optionally incorporates one or more features of any one or more of the preceding and/or following aspects, wherein the interface member comprises a platform.

A system, which optionally incorporates one or more features of any one or more of the preceding and/or following aspects, wherein the manually activated product dispenser comprises a hand cleaning fluid dispenser.

A system, which optionally incorporates one or more features of any one or more of the preceding and/or following aspects, wherein the manually activated product dispenser comprises a towel dispenser.

A system, which optionally incorporates one or more features of any one or more of the preceding and/or following aspects, wherein the manually activated product dispenser comprises a bathroom tissue dispenser.

A system, which optionally incorporates one or more features of any one or more of the preceding and/or following aspects, wherein the kinetic power generator is configured to generate the electrical power by electromagnetism.

A system, which optionally incorporates one or more features of any one or more of the preceding and/or following aspects, wherein the kinetic power generator is configured to generate the electrical power by electrostatic effect.

A system, which optionally incorporates one or more features of any one or more of the preceding and/or following aspects, wherein the message transmitted by the communication device comprises electromagnetic radiation.

A system, which optionally incorporates one or more features of any one or more of the preceding and/or following aspects, wherein the message transmitted by the communication device comprises a radio signal.

A system, which optionally incorporates one or more features of any one or more of the preceding and/or following aspects, wherein the communication device comprises a radio-frequency (RF) device.

A system, which optionally incorporates one or more features of any one or more of the preceding and/or following aspects, wherein the interface member is batteryless.

A system, which optionally incorporates one or more features of any one or more of the preceding and/or following aspects, wherein the interface member is unconnected to an external electrical power supply.

A system, which optionally incorporates one or more features of any one or more of the preceding and/or following aspects, wherein the message includes an interface member identifier that identifies the interface member.

A system, which optionally incorporates one or more features of any one or more of the preceding and/or following aspects, wherein the message includes a dispenser identifier that identifies the manually activated product dispenser.

A system, which optionally incorporates one or more features of any one or more of the preceding and/or following aspects, further comprising a receiver that receives the message transmitted by the communication device.

A system, which optionally incorporates one or more features of any one or more of the preceding and/or following aspects, wherein the receiver is configured to record a time and/or a date that the message is received.

A system, which optionally incorporates one or more features of any one or more of the preceding and/or following aspects, wherein the receiver is configured to determine a number of times that the manually activated product dispenser has been activated by counting the messages that are received from the communication device over time.

A system, which optionally incorporates one or more features of any one or more of the preceding and/or following aspects, wherein the receiver is configured to determine a quantity of a product remaining in the manually activated product dispenser based at least in part on the number of times that the manually activated product dispenser has been activated.

A system, which optionally incorporates one or more features of any one or more of the preceding and/or following aspects, wherein the interface member further comprises: a moveable member that is moveable relative to the support structure between a first position and a second position; a biasing member that biases the moveable member towards the first position; and a switch that is communicatively linked to the communication device; wherein the moveable member is configured to support a weight of the manually activated product dispenser, the weight of the manually activated product dispenser biasing the moveable member towards the second position; wherein the moveable member moves towards the first position under the bias of the biasing member as the weight of the manually activated product dispenser decreases; wherein the switch has a first state and a second state; wherein the moveable member is configured to interact with the switch to toggle the switch between the first state and the second state; wherein, when the moveable member is located between the first position and a threshold position, the switch is in the first state; wherein, when the moveable member is located between the threshold position and the second position, the switch is in the second state; and wherein the message that is transmitted by the communication device includes information as to whether the switch is in the first state or in the second state.

A system, which optionally incorporates one or more features of any one or more of the preceding and/or following aspects, wherein the receiver is configured to determine if a quantity of a product contained in the manually activated product dispenser is below a threshold quantity based at least in part on the message received from the communication device.

A system, which optionally incorporates one or more features of any one or more of the preceding and/or following aspects, further comprising an actuator for the kinetic power generator, the actuator comprising a spring that stores energy provided by the activation force until an energy threshold is reached, and then delivers the stored energy as kinetic energy to the kinetic power generator.

An interface member that is configured to be positioned between a manually activated product dispenser and a support structure, and which optionally incorporates one or more features of any one or more of the preceding and/or following aspects, wherein the interface member comprises: a kinetic power generator; and a communication device; wherein the interface member is configured so that, on manual activation of the manually activated product dispenser, an activation force is transmitted to the kinetic power generator; wherein, on application of the activation force to the kinetic power generator, the kinetic power generator is configured to generate electrical power; wherein the communication device is activated by the electrical power generated by the kinetic power generator; and wherein, on activation, the communication device is configured to transmit a message.

A manually activated product dispenser, which optionally incorporates one or more features of any one or more of the preceding and/or following aspects, comprising: a kinetic power generator; and a communication device; wherein the manually activated product dispenser is configured so that, on manual activation of the manually activated product dispenser, an activation force is transmitted to the kinetic power generator; wherein, on application of the activation force to the kinetic power generator, the kinetic power generator is configured to generate electrical power; wherein the communication device is activated by the electrical power generated by the kinetic power generator; and wherein, on activation, the communication device is configured to transmit a message.

A method, which optionally incorporates one or more features of any one or more of the preceding and/or following aspects, comprising: providing a manually activated product dispenser, a kinetic power generator, and a communication device; arranging the kinetic power generator so that, on manual activation of the manually activated product dispenser, an activation force is transmitted to the kinetic power generator; manually activating the manually activated product dispenser; using the kinetic power generator to generate electrical power from the activation force; using the electrical power to activate the communication device; and on activation of the communication device, using the communication device to transmit a message.

A system, an interface member, a manually activated product dispenser, and/or a method, which optionally incorporates one or more features of any one or more of the preceding and/or following aspects, wherein none of the electrical power generated by the kinetic power generator is stored between activations of the manually activated product dispenser.

A system, which optionally incorporates one or more features of any one or more of the preceding and/or following aspects, comprising: a manually activated product dispenser; and an interface member that is positioned between the manually activated product dispenser and a support structure; wherein the interface member comprises: a kinetic power generator; and a communication device; wherein the interface member is configured so that, on manual activation of the manually activated product dispenser, an activation force is transmitted to the kinetic power generator; wherein, on application of the activation force to the kinetic power generator, the kinetic power generator is configured to generate electrical power; wherein the communication device is activated by the electrical power generated by the kinetic power generator; and wherein, on activation, the communication device is configured to transmit a message.

A system, which optionally incorporates one or more features of any one or more of the preceding and/or following aspects, wherein the interface member comprises a mount for mounting the manually activated product dispenser to the support structure.

A system, which optionally incorporates one or more features of any one or more of the preceding and/or following aspects, wherein the interface member comprises a platform.

A system, which optionally incorporates one or more features of any one or more of the preceding and/or following aspects, wherein the manually activated product dispenser comprises a hand cleaning fluid dispenser.

A system, which optionally incorporates one or more features of any one or more of the preceding and/or following aspects, wherein the manually activated product dispenser comprises a paper towel dispenser.

A system, which optionally incorporates one or more features of any one or more of the preceding and/or following aspects, wherein the manually activated product dispenser comprises a bathroom tissue dispenser.

A system, which optionally incorporates one or more features of any one or more of the preceding and/or following aspects, wherein the kinetic power generator is configured to generate the electrical power by electromagnetism.

A system, which optionally incorporates one or more features of any one or more of the preceding and/or following aspects, wherein the kinetic power generator is configured to generate the electrical power by electrostatic effect.

A system, which optionally incorporates one or more features of any one or more of the preceding and/or following aspects, wherein the message transmitted by the communication device comprises electromagnetic radiation.

A system, which optionally incorporates one or more features of any one or more of the preceding and/or following aspects, wherein the message transmitted by the communication device comprises a radio signal.

A system, which optionally incorporates one or more features of any one or more of the preceding and/or following aspects, wherein the communication device comprises a radio-frequency (RF) device.

A system, which optionally incorporates one or more features of any one or more of the preceding and/or following aspects, wherein the interface member is batteryless.

A system, which optionally incorporates one or more features of any one or more of the preceding and/or following aspects, wherein the interface member is unconnected to an external electrical power supply.

A system, which optionally incorporates one or more features of any one or more of the preceding and/or following aspects, wherein the message includes an interface member identifier that identifies the interface member.

A system, which optionally incorporates one or more features of any one or more of the preceding and/or following aspects, wherein the message includes a dispenser identifier that identifies the manually activated product dispenser.

A system, which optionally incorporates one or more features of any one or more of the preceding and/or following aspects, further comprising a receiver that receives the message transmitted by the communication device.

A system, which optionally incorporates one or more features of any one or more of the preceding and/or following aspects, wherein the receiver is configured to record a time and/or a date that the message is received.

A system, which optionally incorporates one or more features of any one or more of the preceding and/or following aspects, wherein the receiver is configured to determine a number of times that the manually activated product dispenser has been activated by counting the messages that are received from the communication device over time.

A system, which optionally incorporates one or more features of any one or more of the preceding and/or following aspects, wherein the receiver is configured to determine a quantity of a product remaining in the manually activated product dispenser based at least in part on the number of times that the manually activated product dispenser has been activated.

A system, which optionally incorporates one or more features of any one or more of the preceding and/or following aspects, wherein the interface member further comprises: a moveable member that is moveable relative to the support structure between a first position and a second position; a biasing member that biases the moveable member towards the first position; and a switch that is communicatively linked to the communication device; wherein the moveable member is configured to support a weight of the manually activated product dispenser, the weight of the manually activated product dispenser biasing the moveable member towards the second position; wherein the moveable member moves towards the first position under the bias of the biasing member as the weight of the manually activated product dispenser decreases; wherein the switch has a first state and a second state; wherein the switch is configured to toggle between the first state and the second state as the moveable member moves between the first position and the second position; wherein, when the moveable member is located at the first position, the switch is in the first state; wherein, when the moveable member is located at the second position, the switch is in the second state; and wherein the message that is transmitted by the communication device includes information as to whether the switch is in the first state or in the second state.

A system, which optionally incorporates one or more features of any one or more of the preceding and/or following aspects, wherein the receiver is configured to determine if a quantity of a product contained in the manually activated product dispenser is below a threshold quantity based at least in part on the message received from the communication device.

A system, which optionally incorporates one or more features of any one or more of the preceding and/or following aspects, further comprising an activation mechanism for the kinetic power generator, the activation mechanism comprising a spring that stores energy provided by the activation force until an energy threshold is reached, and then delivers the stored energy as kinetic energy to the kinetic power generator.

An interface member that is configured to be positioned between a manually activated product dispenser and a support structure, which optionally incorporates one or more features of any one or more of the preceding and/or following aspects, wherein the interface member comprises: a kinetic power generator; and a communication device; wherein the interface member is configured so that, on manual activation of the manually activated product dispenser, an activation force is transmitted to the kinetic power generator; wherein, on application of the activation force to the kinetic power generator, the kinetic power generator is configured to generate electrical power; wherein the communication device is activated by the electrical power generated by the kinetic power generator; and wherein, on activation, the communication device is configured to transmit a message.

A manually activated product dispenser, which optionally incorporates one or more features of any one or more of the preceding and/or following aspects, comprising: a kinetic power generator; and a communication device; wherein the manually activated product dispenser is configured so that, on manual activation of the manually activated product dispenser, an activation force is transmitted to the kinetic power generator; wherein, on application of the activation force to the kinetic power generator, the kinetic power generator is configured to generate electrical power; wherein the communication device is activated by the electrical power generated by the kinetic power generator; and wherein, on activation, the communication device is configured to transmit a message.

A manually activated product dispenser, which optionally incorporates one or more features of any one or more of the preceding and/or following aspects, wherein the manually activated product dispenser is batteryless.

A manually activated product dispenser, which optionally incorporates one or more features of any one or more of the preceding and/or following aspects, wherein the manually activated product dispenser is unconnected to an external electrical power supply.

A manually activated product dispenser, which optionally incorporates one or more features of any one or more of the preceding and/or following aspects, wherein the message includes a dispenser identifier that identifies the manually activated product dispenser.

A manually activated product dispenser, which optionally incorporates one or more features of any one or more of the preceding and/or following aspects, wherein the manually activated product dispenser comprises a mounting portion that is mounted to a support structure, and a moveable portion that is moveable relative to the mounting portion between a first position and a second position; the manually activated product dispenser further comprising: a biasing member that biases the moveable portion towards the first position; and a switch that is communicatively linked to the communication device; wherein the moveable portion comprises a supply of a product to be dispensed by the manually activated product dispenser; wherein the moveable portion is biased towards the second position by a weight of the supply of the product; wherein the moveable portion moves towards the first position under the bias of the biasing member as the weight of the supply of the product decreases; wherein the switch has a first state and a second state; wherein the switch is configured to toggle between the first state and the second state as the moveable portion moves between the first position and the second position; wherein, when the moveable portion is located at the first position, the switch is in the first state; wherein, when the moveable portion is located at the second position, the switch is in the second state; and wherein the message that is transmitted by the communication device includes information as to whether the switch is in the first state or in the second state.

A method, which optionally incorporates one or more features of any one or more of the preceding and/or following aspects, comprising: providing a manually activated product dispenser, a kinetic power generator, and a communication device; arranging the kinetic power generator so that, on manual activation of the manually activated product dispenser, an activation force is transmitted to the kinetic power generator; manually activating the manually activated product dispenser; using the kinetic power generator to generate electrical power from the activation force; using the electrical power to activate the communication device; and on activation of the communication device, using the communication device to transmit a message.

A system, interface member, manually activated product dispenser, and/or method, which optionally incorporates one or more features of any one or more of the preceding and/or following aspects, wherein none of the electrical power generated by the kinetic power generator is stored between activations of the manually activated product dispenser.

A system, which optionally incorporates one or more features of any one or more of the preceding and/or following aspects, comprising: a manually activated product dispenser; a kinetic power generator; and a communication device; wherein the kinetic power generator is arranged so that, on manual activation of the manually activated product dispenser, an activation force is transmitted to the kinetic power generator; wherein, on application of the activation force to the kinetic power generator, the kinetic power generator is configured to generate electrical power; wherein the communication device is activated by the electrical power generated by the kinetic power generator; and wherein, on activation, the communication device is configured to transmit a message.

### Brief Description of the Drawings

Further aspects and advantages of the invention will appear from the following description taken together with the accompanying drawings, in which:
Figure 1 is a partially exploded perspective view of a fluid dispensing system in accordance with a first embodiment of the present invention;
Figure 1A is a schematic partial side view of the fluid dispensing system shown in Figure 1;
Figure 2 is a perspective view of a fluid dispensing system in accordance with a second embodiment of the present invention;
Figure 3 is a schematic representation of a weight detection mechanism which is optionally incorporated into the fluid dispensing system shown in Figure 1;
Figure 4 is a schematic representation of the weight detection mechanism shown in Figure 3, illustrating a switch in an open state and a closed state;
Figure 5 is a schematic representation of a fluid dispenser in accordance with a third embodiment of the present invention;
Figure 6 is a perspective view of an interface member in accordance with a fourth embodiment of the present invention;
Figure 7 is a perspective view of the interface member shown in Figure 6, with a front panel of the interface member omitted;
Figure 8 is a schematic representation of a network topology of the fluid dispensing system shown in Figure 1;
Figure 9 is a partially exploded perspective view of a fluid dispensing system in accordance with a fifth embodiment of the present invention;
Figure 10 is a partially exploded perspective view of the fluid dispensing system shown in Figure 9, with a front panel of the interface member omitted; and
Figure 11 is a schematic side view of a paper towel dispenser in accordance with a sixth embodiment of the present invention.

### Detailed Description of the Drawings

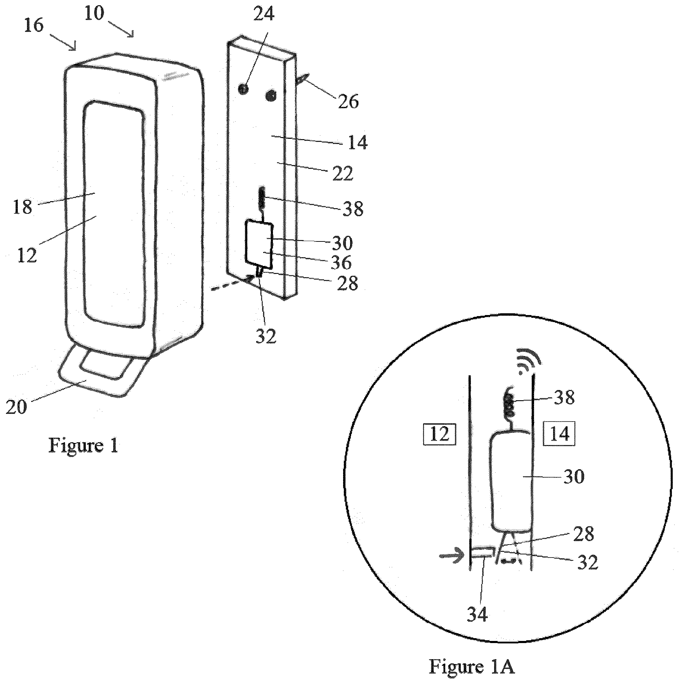

Figure 1 shows a system 10 in accordance with a first embodiment of the present invention. The system 10 includes a manually activated product dispenser 12 and an interface member 14. In the embodiment shown, the system 10 is a fluid dispensing system 16 and the product dispenser 12 is a hand cleaning fluid dispenser 18, though other types of products such as paper towels or bathroom tissue could be dispensed instead.

The fluid dispenser 18 includes an actuator 20 that is manually pushed rearwardly by a user in order to dispense hand cleaning fluid from the dispenser 18, as is known in the art. Any suitable construction of the fluid dispenser 18 could be used, including for example the construction shown in U.S. Patent No. 10,893,780 to Ophardt et al., issued 19 January 2021, which is incorporated herein by reference.

The interface member 14 is designed to be positioned between the product dispenser 12 and a support structure. In the embodiment shown in Figure 1, the interface member 14 is in the form of a back plate 22 for mounting the dispenser 12 to a vertical support structure such as a wall or a post. The back plate 22 preferably includes holes 24 through which fastening devices such as screws 26 may be inserted to secure the back plate 22 to the support structure. Although not visible in Figure 1, the dispenser 12 also includes holes 24 through which the screws 26 are passed in order to mount the dispenser 12 to the back plate 22. Alternatively, any suitable mechanism for mounting the dispenser 12 to the back plate 22 could be used.

As can be seen in Figure 1, the interface member 14 includes a kinetic power generator 28 and a communication device 30. As can be seen in Figure 1A, the kinetic power generator 28 includes a moveable portion 32 that is moveable between a rest position, in which the moveable portion 32 is angled forwardly, and a depressed position, in which the moveable portion 32 is angled rearwardly. As can also be seen in Figure 1A, the dispenser 12 includes an activation member 34 that extends rearwardly towards the moveable portion 32.

The activation member 32 and the kinetic power generator 28 are arranged so that, when a user activates the dispenser 12 by pushing the actuator 20 rearwardly, the activation member 32 moves rearwardly into engagement with the moveable portion 32, moving the moveable portion 32 from the rest position to the depressed position. Some of the force applied by the user to the actuator 20 is thus transmitted to the kinetic power generator 28, and is used by the kinetic power generator 28 to generate electrical power.

The kinetic power generator 28 may use any suitable method of generating electrical power from kinetic energy, including for example electromagnetism (such as induction) or electrostatic effect (such as the piezoelectric effect or electroactive polymers). The electrical power that is generated is used to activate the communication device 30, causing the communication device 30 to transmit a message. In the embodiment shown in Figures 1 and 1A, the communication device 30 is an RF module 36 that transmits the message as a radio signal via an antenna 36, although any other suitable structure for transmitting a message could be used. The message preferably includes information that identifies the dispenser 12 and/or the interface member 14, such as an ID number.

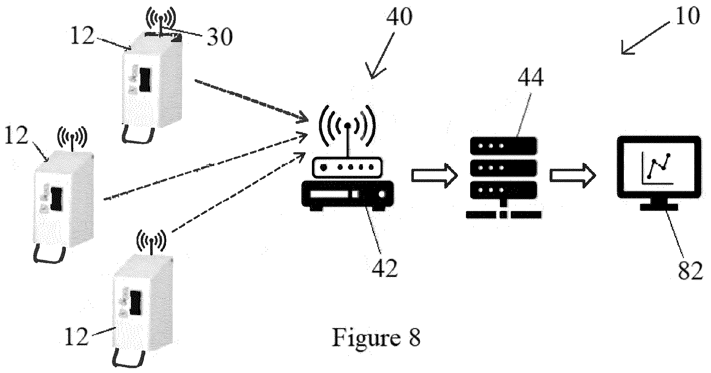

The system 10 preferably includes a receiver 40 that receives the message transmitted by the communication device 30, as shown in Figure 8. The receiver 40 may comprise a single unit that receives and interprets the message, or more preferably a network of components that work together to communicate, process, interpret, deliver, and display information based, at least in part, on the messages that are received from the communication device 30.

An example network topology of the system 10 is shown in Figure 8. The network includes a plurality of dispensers 12, each with an associated interface member 14 (not shown). The messages transmitted by each of the communication devices 30 are received by one or more gateways 42, which relay the messages to a back end 44 for data analysis and processing. The processed data is then provided to a front end 82 for visualization, alerting and maintenance planning, for example.

The system 10 may, for example, be configured to calculate and/or estimate the amount of fluid that is remaining in each dispenser 12 based at least in part on the messages that are received from the communication device 30. For example, by counting the number of dispenser activations over time, and multiplying this number by the known or expected volume of fluid that is dispensed with each activation, the volume of fluid that has been dispensed over time can be calculated. Subtracting this number from the known or expected volume of fluid that was initially contained in the dispenser 12 allows the system 10 to determine how much fluid remains in the dispenser 12. This information can then be used, for example, to send an alert to maintenance staff when the level of fluid is running low and needs to be refilled or replaced.

Preferably, the communication device 30 is configured to require only a small amount of electrical energy to send the message, such that the necessary energy can be generated by the kinetic power generator 28 from the activation force of a single activation of the dispenser 12. This preferably allows the dispenser 12 and the interface member 14 to operate without requiring a battery or any other device for storing electrical energy between activations.

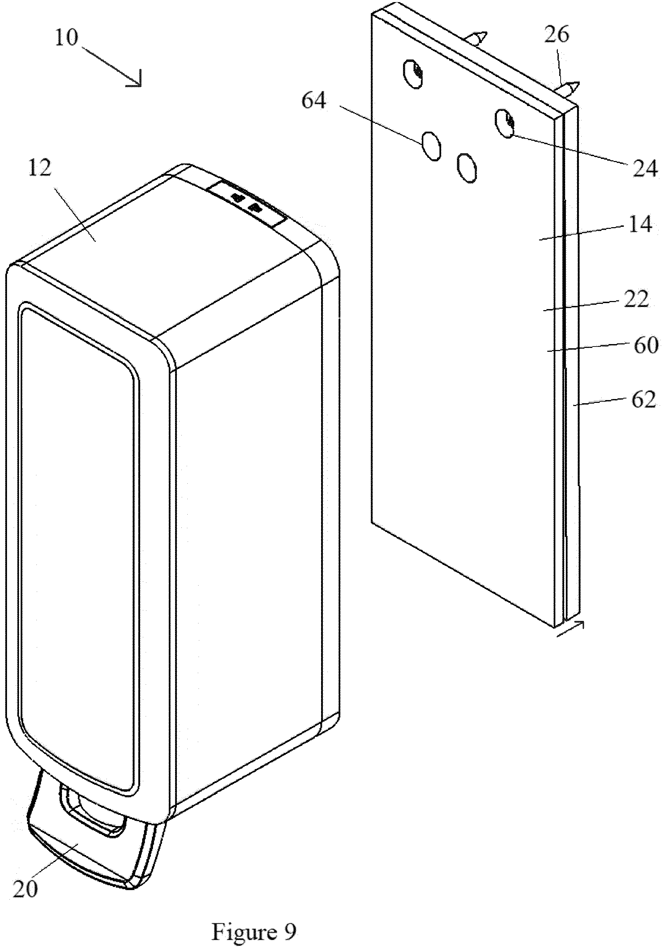

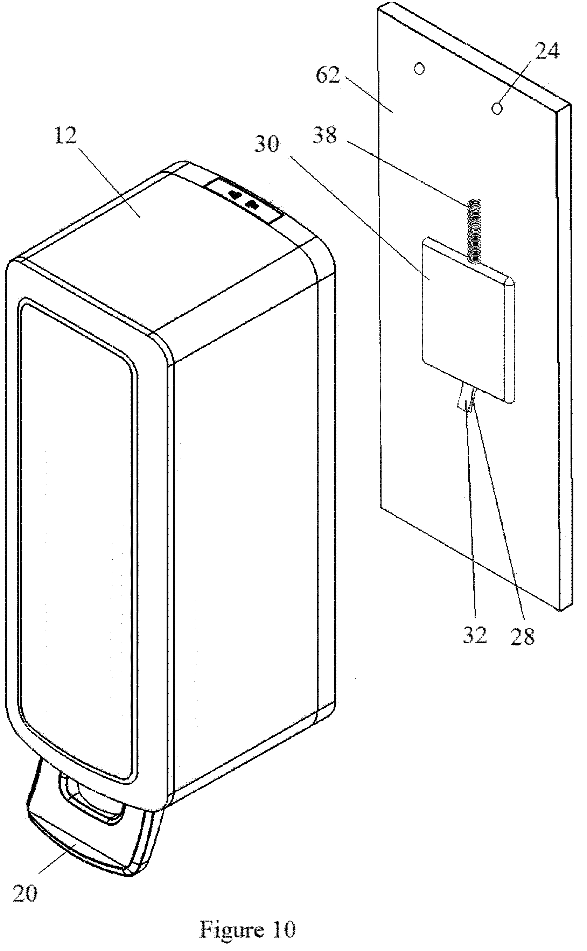

An alternative embodiment of the system 10 in accordance with the present invention is shown in Figures 9 and 10. In the embodiment shown in Figures 9 and 10, the interface member 14 has a front panel 60 and a rear portion 62. The front panel 60 has mounting holes 64 for mounting the dispenser 12 to the panel 60. As can be seen in Figure 10, the rear portion 62 carries the kinetic power generator 28 and the communication device 30.

As can be seen in Figure 9, when the front panel 60 is attached to the rear portion 62, there is a small gap between the front panel 60 and the rear portion 62 at the bottom of the interface member 14. When the dispenser 12 is manually activated, the rearwardly directed activation force pushes the front panel 60 towards the rear portion 62, causing the front panel 60 to engage with and move the moveable portion 32 of the kinetic power generator 28, thus generating electrical power. As in the previous embodiment, the electrical power activates the communication device 30 to transmit a message to the receiver 40.

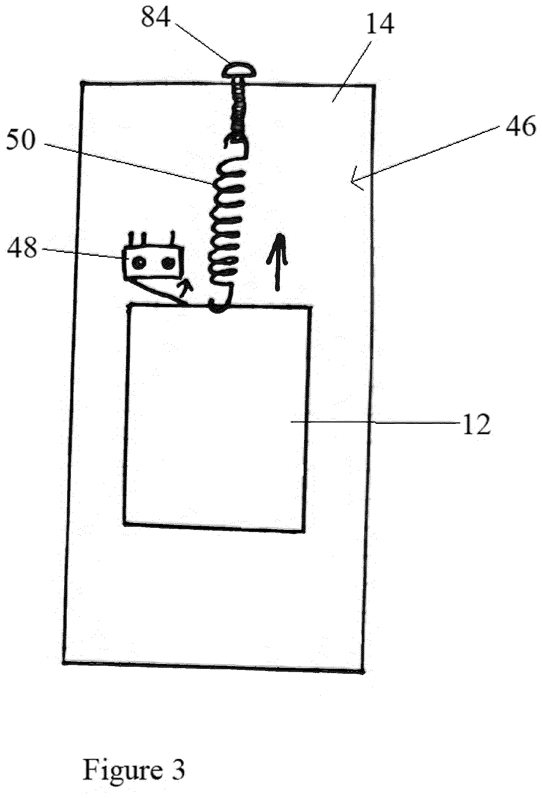

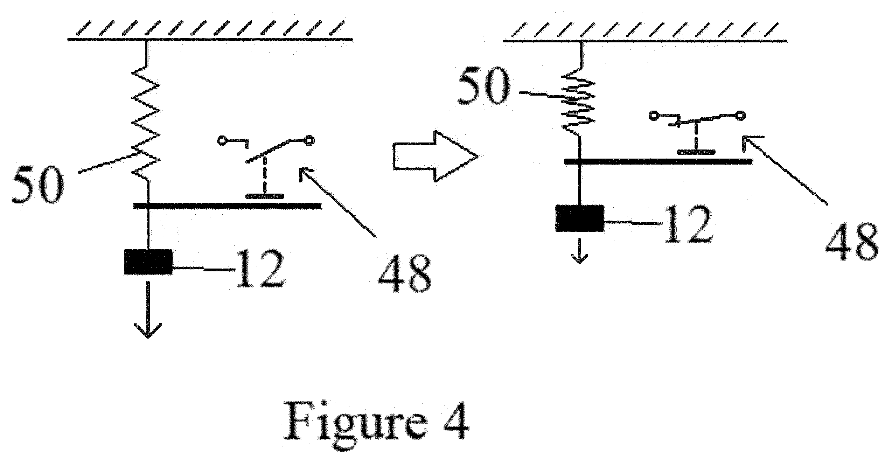

In some preferred embodiments of the invention, the system 10 may be configured to include additional information in the message that is transmitted by the communication device 30. For example, the message may include information from a weight detection mechanism 46 such as that shown in Figures 3 and 4. The weight detection mechanism 46 is configured to provide information about the amount of hand cleaning fluid that is remaining in the dispenser 12, which can be used for example to provide an alert to maintenance staff when the hand cleaning fluid needs to be refilled or replaced.

Preferably, the weight detection mechanism 46 requires very little electrical energy to operate, and provides relatively simple information that can be easily transmitted in a short message. For example, in preferred embodiments of the invention the weight detection mechanism 46 uses a simple mechanical switch 48 to detect whether the fluid is above or below a threshold level.

As can be seen in Figure 3, the weight detection mechanism 46 includes a spring 50 that carries the weight of the dispenser 12, which is shown schematically in Figure 3 as a rectangle. As product is dispensed from the dispenser 12, the weight of the dispenser 12 decreases, which causes the dispenser 12 to travel upwards under the bias of the spring 50. The weight detection mechanism 46 also includes a mechanical switch 48, which can be toggled between a first state and a second state (i.e. an open state and a closed state).

The mechanical switch 48 is arranged so that, when the dispenser 12 travels upwards past a threshold position, the switch 48 is mechanically engaged in a manner that causes the switch 48 to toggle from the first state to the second state. This is shown schematically in Figure 4.

When the dispenser 12 is activated, some of the electrical power that is generated by the kinetic power generator 28 is used to detect whether the switch 48 is in the first state or the second state. This information is then incorporated into the message that is transmitted, and can be used by the receiver 40 to determine whether the volume of fluid remaining in the dispenser 12 is above or below a threshold level. Preferably, the spring 50 is mounted on a screw 84 or other suitable mechanism that allows the height of the spring 50 to be adjusted in order to select the threshold level at which the switch 48 moves from the first state to the second state. The spring 50 is also referred to herein as biasing member 50.

Optionally, the system 10 may include multiple switches 48 that are located at different positions in order to collect additional information about the level of fluid remaining in the dispenser 12. For example, in an embodiment incorporating three switches 48, the first switch 48 may provide information as to whether the dispenser 12 has more or less than half of its fluid remaining; the second switch 48 may provide information as to whether the dispenser 12 has more or less than a quarter of its fluid remaining; and the third switch 48 may provide information as to whether the dispenser 12 has more or less than an eighth of its fluid remaining. This information can then be incorporated into the message that is transmitted on activation, and can be used to schedule maintenance and/or generate maintenance alerts for the dispenser 12.

In some embodiments of the invention, the interface member 14 may be considered to be part of the dispenser 12 itself, such as being the back plate 22 of the dispenser 12. In other embodiments, the interface member 14 could be considered to be an entirely separate component, that may for example be sold separately and be capable of mounting a variety of different dispenser 12 types. The weight detection mechanism 46 could be incorporated entirely into the interface member 14, or alternatively some or all of the components of the weight detection mechanism 46 could incorporated into the dispenser 12.

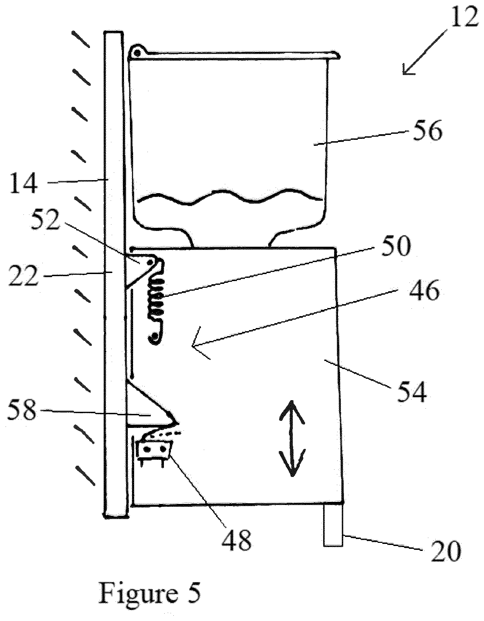

An example of an embodiment in which the weight detection mechanism 46 is incorporated into the dispenser 12 itself is shown in Figure 5. In the embodiment shown in Figure 5, the interface member 14 forms the back plate 22 of the dispenser 12, and is mounted to a vertical wall. A spring holding member 52 extends forwardly from the back plate 22, and carries one end of the spring 50. The other end of the spring 50 is attached to a pump drive 54 of the dispenser 12. The pump drive 54, which carries the weight of the fluid reservoir 56 and the fluid contained therein, hangs on the spring 50 and is free to move up and down relative to the back plate 22 to a limited degree.

A switch engagement member 58 extends forwardly from the back plate 22, and a mechanical switch 48 is mounted on the pump drive 54 below the switch engagement member 58. When the level of fluid within the reservoir 56 decreases, the pump drive 54 moves upwardly relative to the back plate 22 under the bias of the spring 50. When the quantity of fluid remaining in the reservoir 56 reaches a threshold level, causing the pump drive 54 to move up to a corresponding threshold height, the switch 48 engages with the switch engagement member 58. This causes the switch 48 to move from the open state to the closed state. As in the previously described embodiments, information about the state of the switch 48 is incorporated into the message transmitted by the communication device 30. This information can be used by the receiver 40 to determine whether the quantity of fluid remaining in the reservoir 56 is above or below the threshold level.

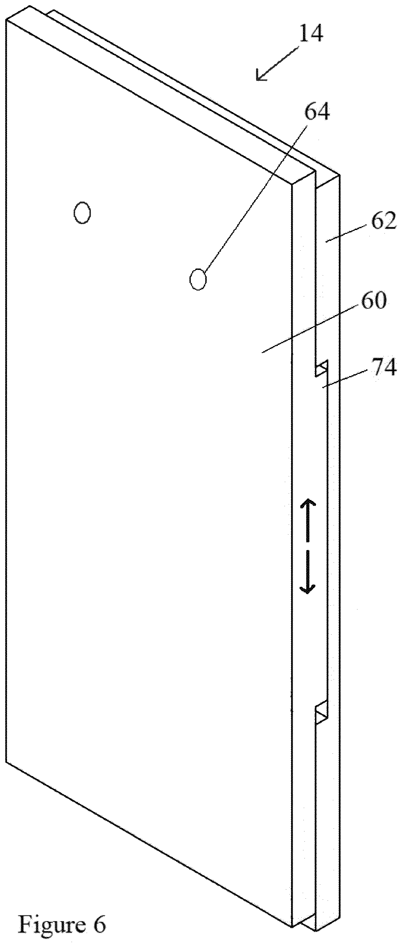

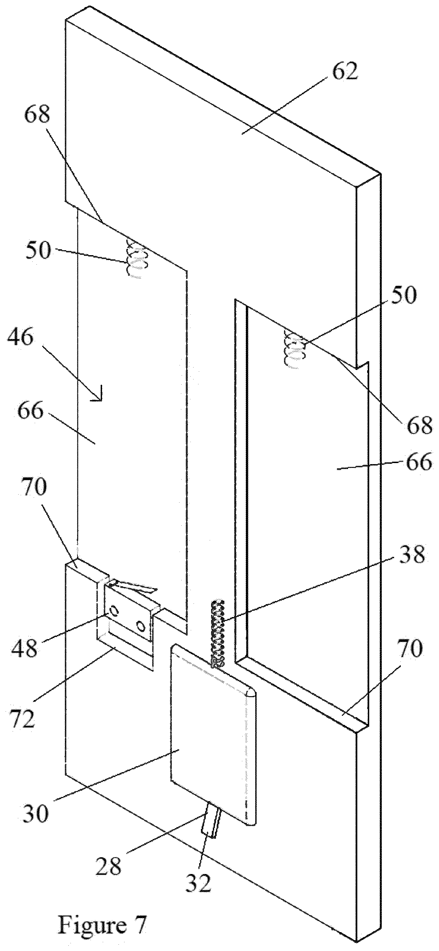

An alternative embodiment is shown in Figures 6 and 7, in which the weight detection mechanism 46 is entirely incorporated into the interface member 14. As can be seen in Figure 6, the interface member 14 includes a front panel 60 and a rear portion 62. The front panel 60 has mounting holes 64 for carrying a product dispenser 12. The front panel 60 is moveable relative to the rear portion 62 between a raised position and a lowered position. The front panel 60 is also referred to herein as the moveable member 60, and the rear portion 62 is also referred to herein as the mounting portion 62.

As can be seen in Figure 7, the rear portion 62 has two forwardly open panel receiving channels 66 that each extend vertically between a top shoulder 68 and a bottom shoulder 70. A spring 50 extends downwardly from each of the top shoulders 68. The bottom shoulder 70 of the left panel receiving channel 66 has a downwardly extending cut-out 72 that carries a mechanical switch 48. As in the previous embodiments, the mechanical switch 48 is moveable between an open state and a closed state. The rear portion 62 also carries a kinetic power generator 28 and a communication device 30. The mechanical switch 48 is communicatively linked to the communication device 30.

The front panel 60 has two rearwardly extending mating extensions 74 that are each received by one of the panel receiving channels 66. The springs 50 are attached to the tops of the mating extensions 74, and bias the front panel 60 upwardly towards the raised position. When the front panel 60 is in the raised position, the bottom of the left mating extension 74 is spaced above the mechanical switch 48.

When a dispenser 12 having a full supply of a fluid or another product to be dispensed is mounted to the front panel 60, the weight of the product pulls the front panel 60 downwardly to the lowered position. This causes the bottom of the left mating extension 74 to engage with the mechanical switch 48, holding the switch 48 in the closed state.

As the product is dispensed from the dispenser 12, the weight of the dispenser 12 decreases, causing the front panel 60 to move upwardly under the bias of the springs 50. Once the product contained within the dispenser 12 has reached a threshold weight, and the front panel 60 has reached a corresponding threshold height, the left mating extension 74 disengages from the switch 48. This causes the switch 48 to revert to the open state.

As in the previous embodiments, when the dispenser 12 is manually activated, the activation force is transmitted to the kinetic power generator 28 to generate electrical power. This can be achieved by movement of the front panel 60 towards the rear portion 62, as in the embodiment shown in Figures 9 and 10, or by any other suitable mechanism. The electrical power activates the communication device 30, causing the communication device 30 to transmit a message to the receiver 40. The message includes information about the state of the switch 48, and can thus be used to determine whether the quantity of product remaining in the dispenser 12 is above or below the threshold weight.

Preferably, the interface member 14 shown in Figures 6 and 7 is configured to be a universal mount, which can provide smart functionality to a variety of different manually activated dispensers 12, without requiring batteries or an external power source.

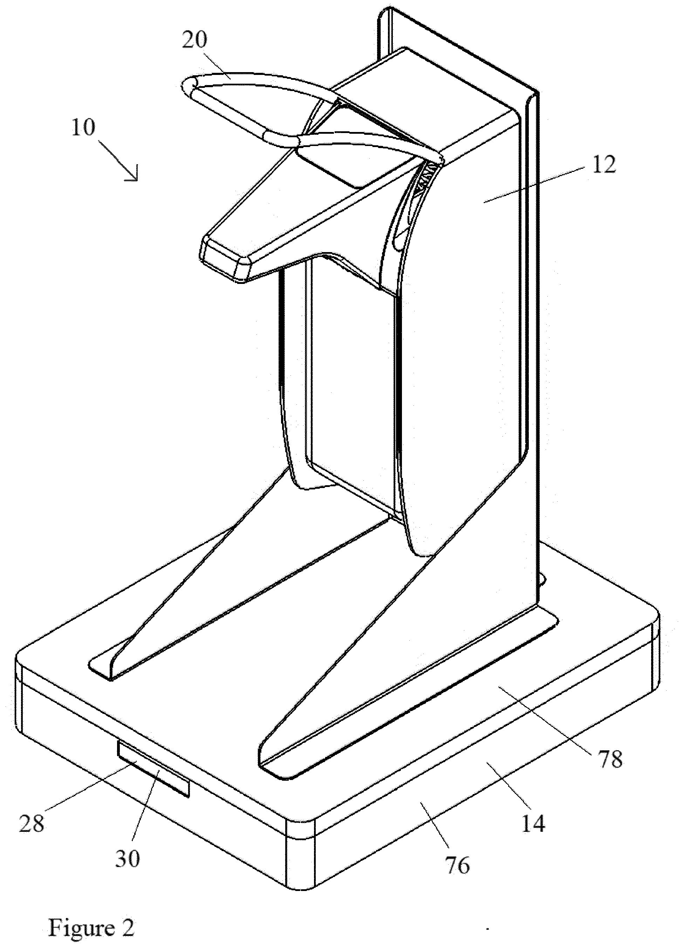

In other embodiments of the invention, such as that shown in Figure 2, the kinetic power generator 28 and the communication device 30 may be incorporated into an interface member 14 in the form of a platform 76 having a horizontal support surface 78 for carrying the dispenser 12. This arrangement is particularly preferred for manually operated dispensers 12 in which the activation force for activating the dispenser 12 is applied downwardly. Optionally, the dispenser 12 may be fastened to the platform 76, or may simply sit on the platform 76 without being attached thereto.

In some preferred embodiments of the invention, the kinetic power generator 28 and the communication device 30 are incorporated into a universal interface member 14, which can function both as a vertical mounting plate 22 for mounting a dispenser 12 to a vertical support surface, as well as a horizontal platform 76 for carrying a dispenser 12 above a horizontal support surface. Preferably, the universal interface member 14 can be used with a wide variety of different manually operated hygiene product dispensers 12, including dispensers 12 in which the activation force is applied horizontally, vertically, or at any other angle. The front panel 60 may include a number of different mounting holes 64 for attaching a variety of different product dispensers 12 thereto.

It will be understood that, although various features of the invention have been described with respect to one or another of the embodiments of the invention, the various features and embodiments of the invention may be combined or used in conjunction with other features and embodiments of the invention as described and illustrated herein.

The invention is not limited to the particular structures of the preferred embodiments that have been shown in the drawings. Rather, any functionally equivalent structures could be used.

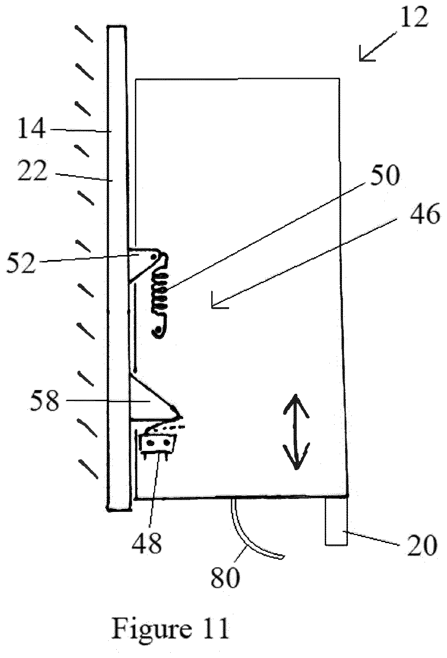

Although the preferred embodiments have described the invention with reference to a manually activated hand cleaning fluid dispenser 18, the invention could be used with other types of manually activated hygiene product dispensers 12 as well. For example, the invention could also be used with a bathroom tissue dispenser 12 and/or a paper towel dispenser 12, as is shown in Figure 11. In the embodiment shown in Figure 11, paper towel 80 is dispensed by a user manually pushing the actuator 20 rearwardly. Although not visible in Figure 11, the interface member 14 incorporates a kinetic power generator 28 and a communication device 30 that function identically to the other embodiments described above. In particular, the activation force applied to the actuator 20 is at least partially transmitted to the kinetic power generator 28, which generates electrical power for activating the communication device 30 to transmit a message to a receiver 40.

The embodiment shown in Figure 11 also incorporates a weight detection mechanism 46, which functions identically to the weight detection mechanism 46 shown in Figure 5. In particular, the weight detection mechanism 46 includes a mechanical switch 48 that toggles between an open state and a closed state depending on the weight of the paper towels 80 remaining in the dispenser 12. Information about the state of the switch 48 is incorporated into the message transmitted by the communication device 30, which can be used by the receiver 40 to determine whether the quantity of paper towels 80 remaining in the dispenser 12 is above or below a threshold value. This information can in turn be used to monitor usage, schedule maintenance, and generate alerts to maintenance staff when the paper towels 80 needs to be refilled.

As used herein, the term "activation force" is intended to refer broadly to any force that is applied to a dispenser 12 and/or the product contained therein in order to dispense the product from the dispenser 12, and may include for example pressing a button, moving a lever, rotating a dial, and/or pulling a piece of paper.

The term "receiver" as used herein is intended to refer broadly to any device and/or network of devices that is involved in receiving and/or processing and/or using the message, directly and/or indirectly, that is transmitted by the communication device 30. In some embodiments of the invention, the message may be detected by a gateway station 42, which then forwards the information to a program that runs on a server, which may be locally hosted or cloud based. The program then processes and uses the data, such as by counting activations of the dispenser 12 over time.

Optionally, the system 10 may incorporate a number of dispensers 12 that are communicatively linked in a network, as shown in Figure 8. Optionally, many dispensers 12 can be connected in a star topology to one gateway station 42. It is also possible to use multiple gateway stations 42 to increase resilience against outages. These gateway stations 42 can be dedicated devices or be integrated into other washroom or healthcare monitoring devices nearby. The gateway station 42 preferably communicates the received data to the back end 44, and ultimately to the front end 82, using wireless or wired communication technology.

Although the kinetic power generator 28 and the communication device 30 have generally been referred to in the preferred embodiments as being incorporated into an interface member 14 that is separate from the dispenser 12, it is to be appreciated that one or more of these components could alternatively be incorporated into the dispenser 12 itself.

The message that is transmitted by the communication device 30 could have any suitable form, including one or more of: electromagnetic radiation, radio wave, Wi-Fi signal, Bluetooth signal, wireless signal, wired signal, optical signal, visual signal, and acoustic signal. Any suitable communication device 30 could be used, including an RF device or RF Module 36. As used herein, the terms "RF Module", "RF device" and "RF electronics" are used interchangeably to refer to any suitable device that can transmit a radio frequency (RF) signal.

The message could include any suitable information, including the identity of the dispenser 12, the location of the dispenser 12, the time of activation, the date of activation, the identity of the user who has activated the dispenser 12, the quantity of product remaining in the dispenser 12, and bottle/reservoir installation status. The system 10 may incorporate additional sensors other than those that have been discussed in the preferred embodiments, and data from those sensors may be included in the message. Preferably, all of the sensors incorporated into the dispenser 12 and/or the interface member 14 are able to operate using only the electrical energy that is generated by a single activation of the dispenser 12. Preferably, measurement of the operating states of the dispenser 12 is done with passive components such as mechanically or magnetically operated switches 48. The term "switch" as used herein is intended to refer broadly to any device or mechanism that can be suitably toggled between two states, such as a simple mechanism in which an electrical contact is opened or closed. In some embodiments of the invention, the system 10 may incorporate a sensor and/or a switch 48 that detects when a reservoir bottle has been removed and/or reinstalled in the dispenser housing. This information can then be used, for example, to restart an activation counter that is being used to calculate and/or estimate the quantity of fluid remaining in the dispenser 12.

Optionally, the system 10 includes a delivery mechanism for delivering kinetic energy to the kinetic power generator 28. The delivery mechanism may include a mechanical energy storage device, such as a leaf spring. The mechanical energy storage device preferably delays the activation of the kinetic power generator 28 (and thus the transmission of the message) until a predetermined threshold, such as lever travel distance, has been reached, while storing the applied energy. This allows for activation of the kinetic power generator 28 in a short but strong stroke, which is preferably advantageous for the efficiency of the power generation.

The term "kinetic power generator" as used herein is intended to refer broadly to any suitable device for converting kinetic energy into electrical energy.

The term "fluid" as used herein is intended to refer broadly to any flowable substance, including liquids, gels, foams, and emulsions. The hand cleaning fluid that is dispensed by the hand cleaning fluid dispenser 18 may include, for example, soap, sanitizer, and/or disinfectant.

Although this disclosure has described and illustrated certain preferred embodiments of the invention, it is to be understood that the invention is not restricted to these particular embodiments. Rather, the invention includes all embodiments which are functional, electrical, or mechanical equivalents of the specific embodiments and features that have been described and illustrated herein.

## Claims

1. A system (10) comprising:
a manually activated product dispenser (12); and
an interface member (14) that is positioned between the manually activated product dispenser (12) and a support structure;
wherein the interface member (14) comprises:
a kinetic power generator (28); and
a communication device (30);
wherein the interface member (14) is configured so that, on manual activation of the manually activated product dispenser (12), an activation force is transmitted to the kinetic power generator (28);
wherein, on application of the activation force to the kinetic power generator (28), the kinetic power generator (28) is configured to generate electrical power;
wherein the communication device (30) is activated by the electrical power generated by the kinetic power generator (28); and
wherein, on activation, the communication device (30) is configured to transmit a message.

2. The system (10) according to claim 1, wherein the interface member (14) comprises a mount for mounting the manually activated product dispenser (12) to the support structure.

3. The system (10) according to claim 1, wherein the interface member (14) comprises a platform (76).

4. The system (10) according to any one of claims 1 to 3, wherein the manually activated product dispenser (12) comprises a hand cleaning fluid dispenser (18).

5. The system (10) according to any one of claims 1 to 4, wherein the communication device (30) comprises a radio-frequency (RF) device.

6. The system (10) according to any one of claims 1 to 5, wherein the interface member (14) is batteryless.

7. The system (10) according to any one of claims 1 to 6, wherein the interface member (14) is unconnected to an external electrical power supply.

8. The system (10) according to any one of claims 1 to 7, wherein the message includes an interface member identifier that identifies the interface member (14).

9. The system (10) according to any one of claims 1 to 8, wherein the message includes a dispenser identifier that identifies the manually activated product dispenser (12).

10. The system (10) according to any one of claims 1 to 9, further comprising a receiver (40) that receives the message transmitted by the communication device (30).

11. The system (10) according to claim 10, wherein the receiver (40) is configured to determine a number of times that the manually activated product dispenser (12) has been activated by counting the messages that are received from the communication device (30) over time.

12. The system (10) according to claim 11, wherein the receiver (40) is configured to determine a quantity of a product remaining in the manually activated product dispenser (12) based at least in part on the number of times that the manually activated product dispenser (12) has been activated.

13. The system (10) according to any one of claims 1 to 12, wherein the interface member (14) further comprises:
a moveable member (60) that is moveable relative to the support structure between a first position and a second position;
a biasing member (50) that biases the moveable member (60) towards the first position; and
a switch (48) that is communicatively linked to the communication device (30);
wherein the moveable member (60) is configured to support a weight of the manually activated product dispenser (12), the weight of the manually activated product dispenser (12) biasing the moveable member (60) towards the second position;
wherein the moveable member (60) moves towards the first position under the bias of the biasing member (50) as the weight of the manually activated product dispenser (12) decreases;
wherein the switch (48) has a first state and a second state;
wherein the switch (48) is configured to toggle between the first state and the second state as the moveable member (60) moves between the first position and the second position;
wherein, when the moveable member (60) is located at the first position, the switch (48) is in the first state;
wherein, when the moveable member (60) is located at the second position, the switch (48) is in the second state; and
wherein the message that is transmitted by the communication device (30) includes information as to whether the switch (48) is in the first state or in the second state.

14. The system (10) according to claim 13, wherein the receiver (40) is configured to determine if a quantity of a product contained in the manually activated product dispenser (12) is below a threshold quantity based at least in part on the message received from the communication device (30).

15. The system (10) according to any one of claims 1 to 14, wherein none of the electrical power generated by the kinetic power generator (28) is stored between activations of the manually activated product dispenser (12).
